# EUROPEAN PATENT SPECIFICATION

(11) **EP 2 667 411 B1**
(45) Date of publication and mention of the grant of the patent: **07.04.2021**
(21) Application number: 12180711.9
(22) Date of filing: 16.08.2012
(51) Int. Cl.: H01L 27/146, H01L 31/0203, H01L 21/56, H01L 21/60, H01L 23/485, H01L 23/31

(54) **Sensing device package structure and method of fabricating the same**
Abtastvorrichtungspaketstruktur und Verfahren zu deren Herstellung
Structure de boîtier de dispositif de détection et son procédé de fabrication

(30) Priority: 25.05.2012 TW 101118729
(43) Date of publication of application: 27.11.2013
(60) Divisional application: 20197731.1
(73) Proprietor: Unimicron Technology Corp., Taoyuan City 333 (TW)
(72) Inventor: Chen, Tsung-Yuan, 330 Taoyuan County (TW); Cheng, Wei-Ming, 807 Kaohsiung City (TW)
(74) Representative: Becker & Kurig Partnerschaft Patentanwälte PartmbB

(56) References cited:
- EP-A2- 1 494 277
- WO-A1-2009/141327
- DE-A1- 4 424 541
- US-A1- 2009 102 002
- US-A1- 2009 212 382
- US-A1- 2011 157 452
- US-B1- 6 661 084

## Description

### BACKGROUND OF THE INVENTION

### 1. Field of the Invention

The invention relates to a method of fabricating a sensing device package structure.

### 2. Description of Related Art

In recent years, as electronic techniques develop rapidly and hi-tech electronic industries come into being in succession, more user-friendly electronic products with better functions are continuously progressing and advancing. Circuit boards are generally disposed to install sensing devices thereon in these electronic products. As the electronic products are continued heading towards the design trend of being light, thin, short, and having a small volume, hence, the thickness of circuit boards is developing towards thinner.

However, in the conventional techniques, firstly, manufacturers respectively fabricate a sensing device and a circuit board for carrying electronic devices. Afterwards, the sensing device is packaged on the circuit board to form a sensing device package structure. Such method not only requires more labor and more time, the overall thickness of the sensing device package structure may not be reduced easily. According to the above described, developing a method capable of fabricating a thinner sensing device package structure is one of the objectives that researchers are intended to achieve.

EP 1 494 277 A2 discloses a module with a built-in semiconductor having inner vias disposed close to a semiconductor device. A module which has a space between a first wiring layer and a built-in semiconductor device is obtained by: mounting the semiconductor device on a first wiring layer of a wiring board; stacking on the circuit board an electrically insulating substrate and an opening for receiving the semiconductor device, and a mold release carrier having a second wiring layer in the stated order; and heating and pressurizing for curing the electrically insulating substrate.

US 6 661 084 B1 discloses a package with an integral window for housing a microelectronic device. The integral window is bonded directly to the package without having a separate layer of adhesive material disposed in-between the window and the package. A glob-top encapsulant or protective cover can be used to protect the microelectronic device and electrical interconnections

US 2011/157452 A1 discloses an optical sensor package having a transparent substrate with a redistribution layer formed on a face thereof, which includes a window and a plurality of electrically conductive traces. A semiconductor substrate, including an optical sensor and a plurality of contact terminals on a face thereof, is positioned on the transparent substrate in a face-to-face arrangement, with the optical sensor directly opposite the window, and with each of the contact terminals electrically coupled to a respective one of the electrically conductive terminals.

US 2009/102002 A1 discloses a semiconductor package including a die having a first side carrying a first bond site electrically connected to a sensor and/or a transmitter configured to receive and/or transmit radiation signals. The semiconductor package also includes encapsulant material at least partially encapsulating a portion of the die. A cover can be positioned adjacent to the die and be generally transparent to a target wavelength.

DE 44 24 541 A1 discloses a process for packaging a solid type image pick-up device. The process includes the steps of: forming a protecting layer on a light receiving region of an image pick-up chip; separating the image pick-up chip after forming the protecting layer; attaching the image pick-up chip on a lead frame and connecting leads of the lead frame to a pad of the separated image pick-up chip; sealing the chip by molding with a resin US 2009/212382 A1 discloses a package comprising an opaque encapsulant and a transparent encapsulant. The opaque encapsulant is formed by molding. A stress buffer layer is provided as to surround a sensing region and protect it during molding.

### SUMMARY OF THE INVENTION

The invention is directed to a method for fabricating a sensing device package structure with small volume and thin overall thickness.

An embodiment of the invention provides a method for fabricating a sensing device package structure as defined in claim 1.

According to the above description, the method of the invention may fabricate a sensing device package structure with thin overall thickness and small volume by embedding the sensing device within the middle dielectric layer. The blocking pattern surrounding the sensing region of the sensing device is utilized to avoid the sensing region of the sensing device being damaged easily during the subsequent fabrication process, thereby improving the production yield of the sensing device package structure.

In order to make the features and advantages of the present invention more comprehensible, the present invention is further described in detail in the following with reference to the embodiments and the accompanying drawings.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1A to FIG. 1J are schematic cross-sectional views of a method for fabricating a sensing device package structure according to an embodiment of the invention.
FIG. 2 is a schematic top view illustrating the sensing device of FIG. 1A.

### DESCRIPTION OF THE EMBODIMENTS

### Method for fabricating a sensing device package structure

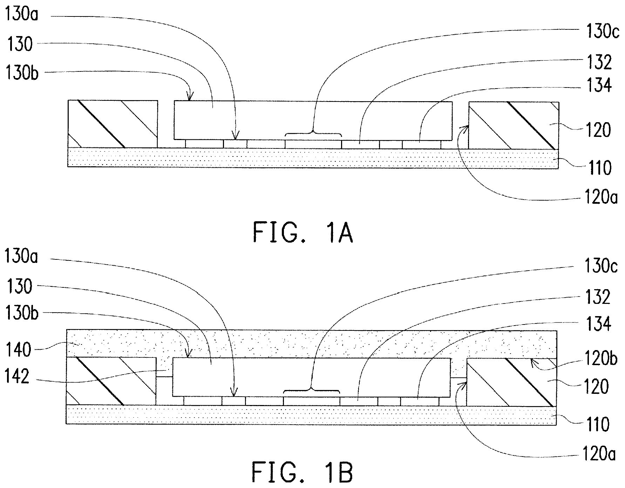

FIG. 1A to FIG. 1J are schematic cross-sectional views of a method for fabricating a sensing device package structure according to an embodiment of the invention. Referring to FIG. 1A to begin with, firstly, an adhesive layer 110 and a middle dielectric layer 120 disposed on the adhesive layer 110 are provided. The middle dielectric layer 120 has a middle opening 120a. The middle opening 120a exposes parts of the adhesive layer 110. In the embodiment, the shape and size of the middle opening 120a may depend on the shape and size of a sensing device intended to be disposed in the middle opening 120a, the invention does not limit the shape or size of the middle opening. The material of the middle dielectric layer 120 in the embodiment may comprise a high molecular polymer and a reinforcing fiber, but the invention is not limited thereto.

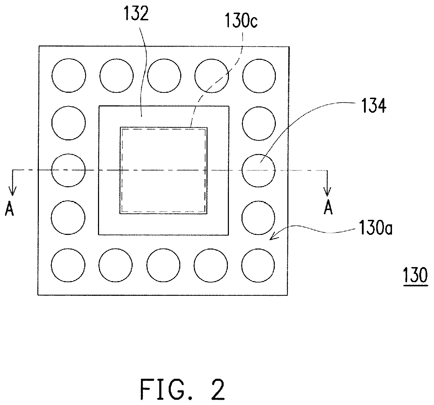

FIG. 2 is a schematic top view illustrating a sensing device of FIG. 1A. More particularly, the cross section of the sensing device in FIG. 1A corresponds to the cross-sectional line A-A of FIG. 2. Referring to FIG. 1A and Fig. 2, next, a front surface 130a of the sensing device 130 is adhered on the adhesive layer 110, so as to position the sensing device 130 in the middle opening 120a. The sensing device 130 has a sensing region 130c located at the front surface 130a, a blocking pattern 132 located at the front surface 130a and surrounding the sensing region 130c, and at least one electrode 134 located at the front surface 130a and outside the blocking pattern 132. The sensing region 130c is a region being utilized to receive optical or acoustical signals. The blocking pattern 132 is utilized to decrease the probability of the sensing region 130c of the sensing device 130 being damaged during the subsequent fabrication process. The electrode 134 is utilized to receive the electric power for driving the sensing device 130. The sensing device 130 may be an optical sensing device (such as an image capturing device) or an acoustical sensing device.

Referring to FIG. 1B, next, a back dielectric layer 140 is formed on a posterior surface 120b of the middle dielectric layer 120 and a back surface 130b opposite to the front surface 130a of the sensing device 130, so as to fix the sensing device 130 in the middle opening 120a of the middle dielectric layer 120. In the embodiment, the back dielectric layer 140 may completely cover the back surface 130b of the sensing device 130 and the posterior surface 120b of the back dielectric layer 140. In addition, a portion 142 of the back dielectric layer 140 may ulteriorly extend between the middle opening 120a and the sensing device 130. The material of the back dielectric layer 140 is, for example, a high molecular polymer.

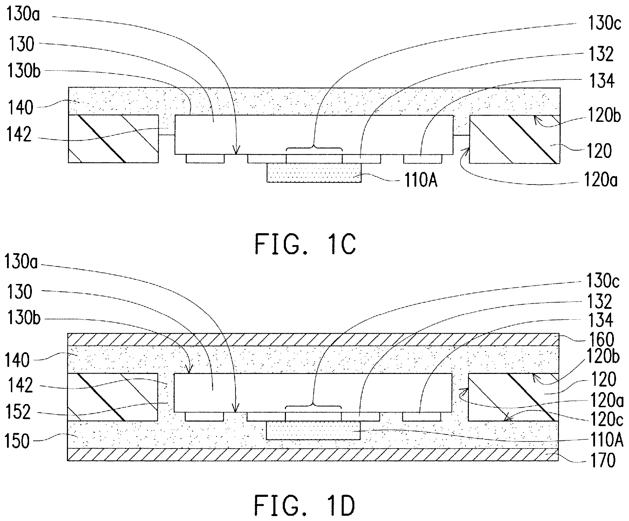

Referring to FIG. 1B and FIG. 1C, next, the adhesive layer 110 is patterned (illustrated in FIG. 1B) to form a patterned adhesive layer 110A (illustrated in FIG. 1C), wherein the patterned adhesive layer 110A covers the sensing region 130c and least parts of the blocking pattern 132, and exposes the electrode 134 and the middle dielectric layer 120. More specifically, in the embodiment, a laser is utilized first to divide the adhesive layer 110 along the blocking pattern 132. Then, the parts of the non-covered sensing region 130c of the adhesive layer 110 are removed, so as to form the patterned adhesive layer 110A. It should be noticed that the patterned adhesive layer 110A covering the sensing region 130c provides the protection function to the sensing region 130c of the sensing device 130 during the subsequent fabrication process, so that each layer formed afterwards may not be in contact with the sensing region 130c easily. More specifically, a gap may exist between the patterned adhesive layer 110A and the sensing region 130c. This means that the patterned adhesive layer 110A is not in contact with the sensing region 130c, therefore, each layer formed on the patterned adhesive layer 110A during the subsequent fabrication process may separate from the sensing region 130c through the patterned adhesive layer 110A to avoid easily creating damages on the sensing region 130c.

Referring to FIG. 1D, next, a front dielectric layer 150 is formed on an anterior surface 120c of the middle dielectric layer 120, the front surface 130a of the sensing device 130 and the patterned adhesive layer 110A, but the front dielectric layer 150 is blocked by the blocking pattern 132 and the patterned adhesive layer 110A, and thus the sensing region 130c of the sensing device 130 is not covered. In the embodiment, a portion 152 of the front dielectric layer 150 may ulteriorly extend between the middle opening 120a and the sensing device 130. The portion 152 of the front dielectric layer 150 may directly connect with a portion 142 of the back dielectric layer 140. The material of the front dielectric layer 150 is, for example, a high molecular polymer.

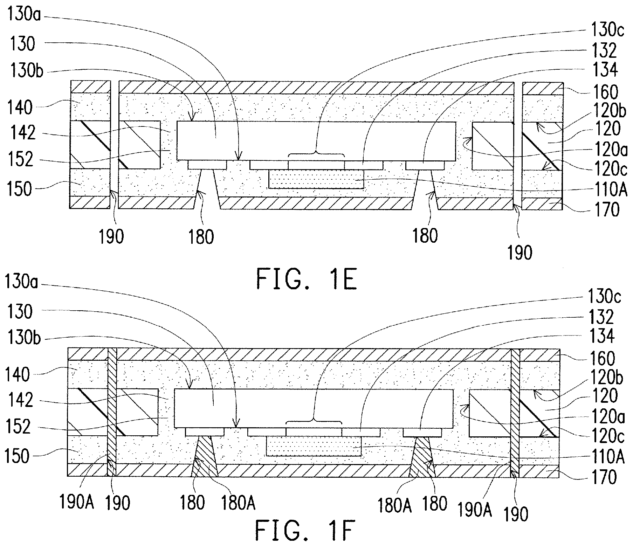

Continuing to refer to FIG. 1D, a front conductive layer 170 is formed on the the front dielectric layer 150 and a back conductive layer 160 may be formed on the back dielectric layer 140. The back conductive layer 160 of the embodiment may completely cover the back dielectric layer 140. The front conductive layer 170 of the embodiment may completely cover the front dielectric layer 150. Referring to FIG. 1E and FIG. 1F, next, at least one front conductive via 180A is formed (illustrated in FIG. 1F), and the front conductive via 180A penetrates through the front dielectric layer 170 to connect to the electrode 134. More specifically, as illustrated in FIG. 1E, at least one opening 180 may firstly be formed in the front conductive layer 170 and the front dielectric layer 150, and the opening 180 exposes the electrode 134. As illustrated in FIG. 1F, then, a conductive material may be filled in the opening 180 to form a front conductive via 180A. An electroplating process may be utilized to form the front conductive via 180A. The front conductive via 180A connects the front conductive layer 170 and the electrode 134.

Continuing to refer to FIG. 1E and FIG. 1F, the method of the embodiment may further comprise the following steps. As illustrated in FIG. 1E, at least one through hole 190 may be formed in the back conductive layer 160, the back dielectric layer 140, the middle dielectric layer 120, the front dielectric layer 150 and the front conductive layer 170. The through hole 190 penetrates through the back conductive layer 160, the back dielectric layer 140, the middle dielectric layer 120, the front dielectric layer 150 and the front conductive layer 170. As illustrated in FIG. 1F, next, at least one through conductive via 190A is formed in the at least one through hole 190. The through conductive via 190A penetrates through the back conductive layer 160, the back dielectric layer 140, the middle dielectric layer 120, the front dielectric layer 150 and the front conductive layer 170. The electroplating process may be utilized to form the through conductive via 190A. The through conductive via 190A connects to the back conductive layer 160 and the front conductive layer 170.

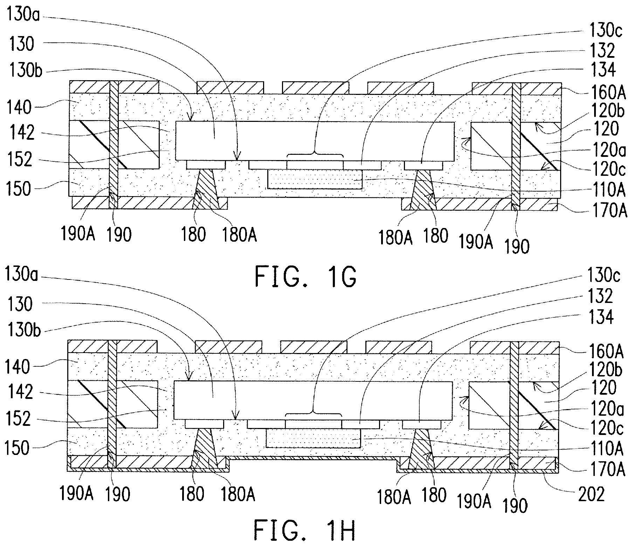

Referring to FIG. 1G, next, a front patterned conductive layer 170A is formed on the front dielectric layer 150 to connect the front conductive via 180A. More specifically, the front conductive layer 170 may be patterned, so as to form the front patterned conductive layer 170A. The front conductive layer 170 already connects with the front conductive via 180A before being patterned, and the front conductive layer 170 after being patterned (that is, the front patterned conductive layer 170A) also connects with the front conductive via 180A. While forming the front patterned conductive layer 170A, together with, a back patterned conductive layer 160A may be formed on the back dielectric layer 140. More specifically, the back conductive layer 160 may be patterned, so as to form the back patterned conductive layer 160A. The back conductive layer 160 and the front conductive layer 170 already connect with the through conductive via 190A before being patterned, and the back conductive layer 160 and the front conductive layer 170 after being patterned (that is, the back patterned conductive layer 160A and the front patterned conductive layer 170A) also connect with the through conductive via 190A.

Referring to FIG. 1H, next, a solder mask layer 202 may be selectively formed on the front dielectric layer 150 and the front patterned conductive layer 170A. The solder mask layer 202 may completely cover the front dielectric layer 150 and the front patterned conductive layer 170A.

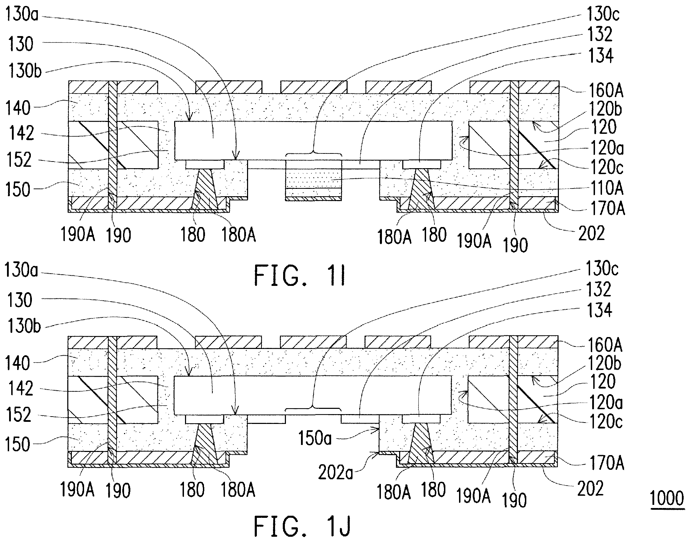

Referring to FIG. 1I, next, a laser (not illustrated) is utilized to divide the front dielectric layer 150 and the patterned adhesive layer 110A along the blocking pattern 132. Referring to FIG. 1J, then, the patterned adhesive layer 110A and the parts of the front dielectric layer 150 thereon are removed, so as to expose the sensing region 130c. Referring to FIG. 1I, according to an example not forming part of the claimed invention but useful for its understanding, in the step of dividing the front dielectric layer 150, the laser may simultaneously be utilized to divide the solder mask layer 202, the front dielectric layer 150 and the patterned adhesive layer 110A. Referring to FIG. 1J, in the step of removing the patterned adhesive layer 110A and the parts of the front dielectric layer 150 thereon, the patterned adhesive layer 110A, the parts of the front dielectric layer 150 thereon and the parts of the solder mask layer 202 thereon may simultaneously be removed to expose the sensing region 130c. Accordingly, a sensing device package structure 1000 is completed.

In the method of the embodiment, it should be noted that since the sensing device 130 is embedded within the middle dielectric layer 120, the sensing device package structure 1000 fabricated by the method of the embodiment may have thin overall thickness and small volume. In addition, in the method of the embodiment, the laser is utilized to divide the front dielectric layer 150 and the patterned adhesive layer 110A along the blocking pattern 132, thereby removing the patterned adhesive layer 110A and the parts of the front dielectric layer 150 thereon to expose the sensing region 130c. Therefore, the sensing region 130c of the sensing device 130 may not be damaged easily during the process of dividing and removing the parts of the front dielectric layer 150 and the patterned adhesive layer 110A, thereby increasing the production yield of the sensing device package structure 1000.

### Sensing device package structure

Referring to FIG. 1I, the sensing device package structure 1000 according to an example useful for understanding of the present invention comprises a middle dielectric layer 120, a sensing device 130, a front dielectric layer 150, a front patterned conductive layer 170A and at least one front conductive via 180A.

The middle dielectric layer 120 has an anterior surface 120c, a posterior surface 120b opposite to the anterior surface 120c, and a middle opening 120a connecting the anterior surface 120c and the posterior surface 120b. The sensing device 130 is disposed in the middle opening 120a. The sensing device 130 has a front surface 130a, a back surface 130b opposite to the front surface 130a, a sensing region 130c located at the front surface 130a, a blocking pattern 132 located at the front surface 130a and surrounded the sensing region 130c, and at least one electrode 134 located at the front surface 130a and outside the blocking pattern 132. The sensing device 130 may be an optical sensing device or an acoustical sensing device.

The front dielectric layer 150 is disposed on the anterior surface 120c of the middle dielectric layer 120 and the front surface 130a of the sensing device 130. The front dielectric layer 150 has a front opening 150a exposed the sensing region 130c and the blocking pattern 132. A portion 152 of the front dielectric layer 150 may extend between the middle opening 120a and the sensing device 130. The front patterned conductive layer 170A is disposed on the front dielectric layer 150. The at least one front conductive via 180A penetrates through the front dielectric layer 150 and connects the front patterned conductive layer 170A and the electrode 134.

The sensing device package structure 1000 may further comprise a back dielectric layer 140. The back dielectric layer 140 may be disposed on the posterior surface 120b of the middle dielectric layer 120 and the back surface 130b opposite to the front surface 130a of the sensing device 130. A portion 142 of the back dielectric layer 140 may extend between the middle opening 120a and the sensing device 130. More specifically, the portion 142 of the back dielectric layer 140 may directly connect with the portion 152 of the front dielectric layer 150.

The sensing device package structure 1000 further comprises a back patterned conductive layer 160A. The back patterned conductive layer 160A is disposed on the back dielectric layer 140. The sensing device package structure 1000 further comprises at least one through conductive via 190A. The through conductive via 190A penetrates through the front dielectric layer 150, the middle dielectric layer 120 and the back dielectric layer 140, and connects the front patterned conductive layer 170A and the back patterned conductive layer 160A. The sensing device package structure 1000 further comprises a solder mask layer 202. The solder mask layer 202 is disposed on the front dielectric layer 150 and the front patterned conductive layer 170A. The solder mask layer 202 has an opening 202a. The opening 202a exposes the sensing region 130c and the blocking pattern 132. The opening 202a may be flush with the front opening 150a.

In the sensing device package structure 1000, it should be noted that since the sensing device 130 is embedded within the middle dielectric layer 120, the sensing device package structure 1000 may have thin overall thickness and small volume.

According to the above description, the method of an embodiment of the invention may fabricate a sensing device package structure with thin overall thickness and small volume by embedding the sensing device within the middle dielectric layer. In addition, in the method, the laser is utilized to divide the front dielectric layer and the patterned adhesive layer along the blocking pattern, thereby removing the patterned adhesive layer and the parts of the front dielectric layer thereon to expose the sensing region. Therefore, the sensing region of the sensing device may not be damaged easily during the process of dividing and removing the parts of the front dielectric layer and the patterned adhesive layer, thereby increasing the production yield of the sensing device package structure.

## Claims

1. A method for fabricating a sensing device package structure, comprising:
providing an adhesive layer (110) and a middle dielectric layer (120) disposed on the adhesive layer (110), wherein the middle dielectric layer (120) has a middle opening (120a), and the middle opening (120a) exposes parts of the adhesive layer (110);
adhering a front surface (130a) of a sensing device (130) on the adhesive layer (110) to position the sensing device (130) in the middle opening (120a), wherein the sensing device (130) has a sensing region (130c) located at the front surface (130a), a laser blocking pattern (132) located at the front surface (130a) and surrounding the sensing region (130c) and at least one electrode (134) located at the front surface (130a) and outside the laser blocking pattern (132), wherein the laser blocking pattern (132) protrudes from the front surface (130a) of the sensing device (130);
forming a back dielectric layer (140) on a posterior surface (120b) of the middle dielectric layer (120) and a back surface (130b) opposite to the front surface (130a) of the sensing device (130) to fix the sensing device (130) in the middle opening (120a) of the middle dielectric layer (120);
patterning the adhesive layer (110) to form a patterned adhesive layer (110A), wherein the patterned adhesive layer (110A) covers the sensing region (130c) and least parts of the laser blocking pattern (132) and exposes the electrode (134) and the middle dielectric layer (120), wherein steps of patterning the adhesive layer (110) comprise:
utilizing a laser to divide the adhesive layer (110) along the blocking pattern (132); and
removing parts of the non-covered sensing region (130c) of the adhesive layer (110); the method further comprising:
forming a front dielectric layer (150) on the anterior surface (120c) of the middle dielectric layer (120), the front surface (130a) of the sensing device (130) and the patterned adhesive layer (110A), wherein the front dielectric layer (150) is blocked by the laser blocking pattern (132) and the patterned adhesive layer (110A), and thus the sensing region (130c) of the sensing device (130) is not covered;
forming at least one front conductive via (180A) penetrating through the front dielectric layer (150) to connect to the electrode (134);
forming a front patterned conductive layer (170A) on the front dielectric layer (150) to connect the front conductive via (180A);
utilizing a laser to divide the front dielectric layer (150) and the patterned adhesive layer (110A) along the laser blocking pattern (132); and
removing the patterned adhesive layer (110A) and the parts of the front dielectric layer (150) thereon to expose the sensing region (130c).

2. The method as recited in claim 1, wherein a portion of the back dielectric layer (140) extends between the middle opening (120a) and the sensing device (130).

3. The method as recited in claim 1, wherein a portion of the front dielectric layer (150) extends between the middle opening (120a) and the sensing device (130).

4. The method as recited in claim 1, further comprising:
forming a back patterned conductive layer (160A) on the back dielectric layer (140).

5. The method as recited in claim 1, further comprising:
forming at least one through conductive via (190A), wherein the through conductive via (190A) penetrates through the front dielectric layer (150), the middle dielectric layer (120) and the back dielectric layer (140), and connects the front patterned conductive layer (170A) and the back patterned conductive layer (160A).

## Patentansprüche

1. Verfahren zum Herstellen einer Sensorvorrichtungspackungsstruktur, umfassend:
Bereitstellen einer Klebeschicht (110) und einer mittleren dielektrischen Schicht (120), die auf der Klebeschicht (110) angeordnet ist, wobei die mittlere dielektrische Schicht (120) eine mittlere Öffnung (120a) aufweist und die mittlere Öffnung (120a) Teile der Klebeschicht (110) freilegt;
Aufkleben einer vorderen Oberfläche (130a) einer Sensorvorrichtung (130) auf die Klebeschicht (110), um die Sensorvorrichtung (130) in der mittleren Öffnung (120a) zu positionieren, wobei die Sensorvorrichtung (130) einen Sensorbereich (130c) aufweist, der sich an der vorderen Oberfläche (130a) befindet, ein Laserblockiermuster (132), das sich an der vorderen Oberfläche (130a) befindet und den Sensorbereich (130c) umgibt, und wenigstens eine Elektrode (134), die sich an der vorderen Oberfläche (130a) und außerhalb des Laserblockiermusters (132) befindet, wobei das Laserblockiermuster (132) von der vorderen Oberfläche (130a) der Sensorvorrichtung (130) vorsteht;
Ausbilden einer hinteren dielektrischen Schicht (140) auf einer rückseitigen Oberfläche (120b) der mittleren dielektrischen Schicht (120) und einer hinteren Oberfläche (130b) gegenüber der vorderen Oberfläche (130a) der Sensorvorrichtung (130), um die Sensorvorrichtung (130) in der mittleren Öffnung (120a) der mittleren dielektrischen Schicht (120) zu befestigen;
Strukturieren der Klebeschicht (110), um eine gemusterte Klebeschicht (110A) zu bilden, wobei die strukturierte Klebeschicht (110A) den Sensorbereich (130c) und zumindest Teile des Laserblockiermusters (132) bedeckt und die Elektrode (134) und die mittlere dielektrische Schicht (120) freilegt, wobei Schritte des Strukturierens der Klebeschicht (110) umfassen:
Verwenden eines Lasers, um die Klebeschicht (110) entlang des Blockiermusters (132) zu teilen; und
Entfernen von Teilen des nicht bedeckten Sensorbereichs (130c) der Klebeschicht (110); wobei das Verfahren ferner umfasst:
Ausbilden einer vorderen dielektrischen Schicht (150) auf der vorderseitigen Oberfläche (120c) der mittleren dielektrischen Schicht (120), der vorderen Oberfläche (130a) der Sensorvorrichtung (130) und der gemusterten Klebeschicht (110A), wobei die vordere dielektrische Schicht (150) durch das Laserblockiermuster (132) und die gemusterte Klebeschicht (110A) blockiert ist und somit der Sensorbereich (130c) der Sensorvorrichtung (130) nicht abgedeckt ist;
Ausbilden mindestens eines vorderen leitenden Durchgangs (180A), der die vordere dielektrische Schicht (150) durchdringt, um sich mit der Elektrode (134) zu verbinden;
Ausbilden einer vorderen gemusterten leitenden Schicht (170A) auf der vorderen dielektrischen Schicht (150), um sich mit dem vorderen leitenden Durchgang (180A) zu verbinden;
Verwenden eines Lasers, um die vordere dielektrische Schicht (150) und die gemusterte Klebeschicht (110A) entlang des Laserblockiermusters (132) zu teilen; und
Entfernen der gemusterte Klebeschicht (110A) und der Teile der vorderen dielektrischen Schicht (150) darauf, um den Sensorbereich (130c) freizulegen.

2. Verfahren gemäß Anspruch 1, wobei sich ein Abschnitt der hinteren dielektrischen Schicht (140) zwischen der mittleren Öffnung (120a) und der Sensorvorrichtung (130) erstreckt.

3. Verfahren gemäß Anspruch 1, wobei sich ein Abschnitt der vorderen dielektrischen Schicht (150) zwischen der mittleren Öffnung (120a) und der Sensoreinrichtung (130) erstreckt.

4. Verfahren gemäß Anspruch 1, ferner umfassend:
Ausbilden einer hinteren gemusterten leitenden Schicht (160A) auf der hinteren dielektrischen Schicht (140).

5. Verfahren gemäß Anspruch 1, ferner umfassend:
Ausbilden mindestens eines durchgehenden leitenden Durchgangs (190A), wobei der durchgehende leitende Durchgang (190A) die vordere dielektrische Schicht (150), die mittlere dielektrische Schicht (120) und die hintere dielektrische Schicht (140) durchdringt und die vordere strukturierte leitende Schicht (170A) und die hintere strukturierte leitende Schicht (160A) verbindet.

## Revendications

1. Procédé de fabrication d'une structure de boîtier de dispositif de détection, comprenant :
la fourniture d'une couche adhésive (110) et d'une couche électrique centrale (120) disposée sur la couche adhésive (110), dans lequel la couche électrique centrale (120) comporte une ouverture centrale (120a), et l'ouverture centrale (120a) expose des parties de la couche adhésive (110) ;
l'adhésion d'une surface avant (130a) d'un dispositif de détection (130) sur la couche adhésive (110) afin de positionner le dispositif de détection (130) dans l'ouverture centrale (120a), dans lequel le dispositif de détection (130) comporte une région de détection (130c) située au niveau de la surface avant (130a), un motif de blocage de laser (132) situé au niveau de la surface avant (130a) et entourant la région de détection (130c) et au moins une électrode (134) située au niveau de la surface avant (130a) et en dehors du motif de blocage de laser (132), dans lequel le motif de blocage de laser (132) fait saillie depuis la surface avant (130a) du dispositif de détection (130) ;
la formation d'une couche diélectrique arrière (140) sur une surface postérieure (120b) de la couche diélectrique centrale (120) et d'une surface arrière (130b) située à l'opposé de la surface avant (130a) du dispositif de détection (130) afin d'attacher le dispositif de détection (130) dans l'ouverture centrale (120a) de la couche diélectrique centrale (120) ;
le modelage de la couche adhésive (110) afin de former une couche adhésive à motifs (110A), dans lequel la couche adhésive à motifs (110A) recouvre la région de détection (130c) et au moins des parties du motif de blocage de laser (132) et expose l'électrode (134) et la couche diélectrique centrale (120), dans lequel les étapes de modelage de la couche adhésive (110) comprennent :
l'utilisation d'un laser afin de diviser la couche adhésive (110) le long du motif de blocage (132) ; et
l'élimination de parties de la région de détection non recouverte (130c) de la couche adhésive (110) ;
le procédé comprenant en outre :
la formation d'une couche diélectrique avant (150) située sur la surface intérieure (120c) de la couche diélectrique centrale (120), la surface avant (130a) du dispositif de détection (130) et la couche adhésive à motifs (110A), dans lequel la couche diélectrique avant (150) est bloquée par le motif de blocage de laser (132) et la couche adhésive à motifs (110A), et ainsi la région de détection (130c) du dispositif de détection (130) n'est pas recouverte ;
la formation d'au moins un trou conducteur avant (180A) pénétrant à travers la couche diélectrique avant (150) afin d'être relié à l'électrode (134) ;
la formation d'une couche conductrice à motifs avant (170A) située sur la couche diélectrique avant (150) afin de connecter le trou conducteur avant (180A) ;
l'utilisation d'un laser afin de diviser la couche diélectrique avant (150) et la couche adhésive à motifs (110A) le long du motif de blocage de laser (132) ; et l'élimination de la couche adhésive à motifs (110A) et des parties de la couche diélectrique avant (150) située sur celle-ci afin d'exposer la région de détection (130c).

2. Procédé selon la revendication 1, dans lequel une partie de la couche diélectrique arrière (140) s'étend entre l'ouverture centrale (120a) et le dispositif de détection (130).

3. Procédé selon la revendication 1, dans lequel une partie de la couche diélectrique avant (150) s'étend entre l'ouverture centrale (120a) et le dispositif de détection (130).

4. Procédé selon la revendication 1, comprenant en outre :
la formation d'une couche conductrice à motifs arrière (160A) située sur la couche diélectrique arrière (140).

5. Procédé selon la revendication 1, comprenant en outre :
la formation d'au moins un trou conducteur traversant (190A), dans lequel le trou conducteur traversant (190A) pénètre à travers la couche diélectrique avant (150), la couche diélectrique centrale (120) et la couche diélectrique arrière (140), et connecte la couche conductrice à motifs avant (170A) et la couche conductrice à motifs arrière (160A).
